Europäisches Patentamt

European Patent Office

Office européen des brevets

(19)

(11) Publication number:

**0 354 691**
**A2**

(12) # EUROPEAN PATENT APPLICATION

(21) Application number: 89307712.3

(51) Int. Cl.⁴: **G03F 7/00**

(22) Date of filing: 28.07.89

(30) Priority: 09.08.88 JP 198502/88
22.11.88 JP 295062/88
17.04.89 JP 97182/89
21.04.89 JP 102282/89

(43) Date of publication of application:
**14.02.90 Bulletin 90/07**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**

(72) Inventor: **Abe, Nobumasa**
**c/o SEIKO EPSON CORP. 3-5 Owa 3-chome**
**Suwa-shi Nagano-ken(JP)**
Inventor: **Kobayashi, Atsushi**
**c/o SEIKO EPSON CORP. 3-5 Owa 3-chome**
**Suwa-shi Nagano-ken(JP)**
Inventor: **Watanabe, Koji**
**c/o SEIKO EPSON CORP. 3-5 Owa 3-chome**
**Suwa-shi Nagano-ken(JP)**
Inventor: **Morishita, Norio**
**c/o SEIKO EPSON CORP. 3-5 Owa 3-chome**
**Suwa-shi Nagano-ken(JP)**
Inventor: **Tanaka, Yuji**
**c/o SEIKO EPSON CORP. 3-5 Owa 3-chome**
**Suwa-shi Nagano-ken(JP)**

(74) Representative: **Miller, Joseph et al**
**J. MILLER & CO. Lincoln House 296-302 High**
**Holborn**
**London WC1V 7JH(GB)**

(54) **Image-creating apparatus.**

(57) An image-creating apparatus comprising a container (2) for holding a photosensitive member (f) provided with a plurality of microcapsules containing at least a colour former and a material which hardens or softens when exposed to light; an exposure means (7,9) which exposes the photosensitive member (f) to an optical image; a container (15) for holding a sheet (s) on which a visible image is to be created; development means (100) in which the photosensitive member (f) and the sheet (s) are superimposed and in which the sheet (s) is developed under pressure; and thermal treating means (400) for thermally treating the developed sheet (s).

Fig. 1

## IMAGE-CREATING APPARATUS

The present invention relates to an image-creating apparatus which is arranged to expose a photosensitive member to an optical image and to make this image visible on another member.

Methods of creating images as disclosed in US-A-3,219,446, JP-A-88739/1983 and JP-A-30537.1984 use photosensitive materials which harden or soften when exposed to light. These methods also employ materials which can be transferred. The transferability of these materials is controlled to create images. These known methods involve simpler steps subsequent to exposure than do silver salt photographic methods, and offer better image quality by gradation than is produced by electro-photography.

The first-mentioned methods use development means all of which apply constant pressure. These methods have the disadvantage that the image concentration changes, the homogeneity of the concentration is lost, and creases are produced, depending on the width, the thickness, and the quality of sheets, such as paper including normal paper and OHP paper, on which visible images are created.

According to the present invention there is provided an image-creating apparatus comprising a container for holding a photosensitive member provided with a plurality of microcapsules containing at least a colour former and a material which hardens or softens when exposed to light; an exposure means which exposes the photosensitive member to an optical image; a container for holding a sheet on which a visible image is to be created; development means in which the photosensitive member and the sheet are superimposed and in which the sheet is developed under pressure; and thermal treating means for thermally treating the developed sheet.

Preferably, the development means comprises pressure rollers and pressure adjusting means for adjusting the pressure applied by the pressure rollers.

The pressure adjusting means may comprise a pressure spring for urging the pressure rollers into pressure contact with each other, and means for adjusting the effective force of the pressure spring.

There may be means for adjusting the point of application of the force of the pressure spring at a time when the pressure rollers are out of contact with each other.

Means may be provided for imparting force to the pressure spring.

Such means may comprise a cam mounted on a cam shaft, there being provided a further spring and means for selectively permitting and preventing the application of the force of the further spring to the cam shaft.

Preferably, there are detector means for detecting a characteristic of the sheet which is to be developed, the pressure produced by the development means being controlled by the detector means.

The thermal treating means preferably comprises a radiation heater which is arranged to heat the developed sheet by radiation heat to a temperature above the softening point of the material forming the said visible image.

There may be a movable heat-insulating member which is mounted between the heater and the sheet and which is movable to adjust the area of the sheet which is being heated.

The thermal treating means may comprise a support member for supporting the sheet, the support member extending in a direction which is not parallel to the direction in which in operation the sheet is moved through the thermal treating means.

Gas-removing means are preferably provided for removing gas produced in the thermal treating means.

The gas-removing means may comprise a duct for discharging the said gas, a gas filter being mounted in the duct for removing gaseous components in the duct.

The filter is preferably provided with manually operable means for introducing it into and withdrawing it from the apparatus.

Monitor means may be provided for monitoring the state of the filter.

The gas-removing means may comprise an adsorbing portion and an absorbing member which are mounted on the upstream side of the gas filter.

In one embodiment, the gas-removing means is integral with the container for holding the photosensitive member.

In its preferred form, the image-creating apparatus of the present invention enables the best image quality to be provided in various conditions.

The thermal treating means may heat the colour former or a developer on the sheeet to a temperature above the softening point and may melt it to remove the irregularities of the surface. As a result, a lustrous and vivid image can be obtained.

It is to be noted, however, that lustrous images exhibit various degrees of lustre. Gloss is a measure of the degree of lustre. Generally, the gloss of paperlike substances is measured in terms of 75° gloss. The desired degree of gloss depends on taste. For example, some people like images of more than 90 in terms of 75° gloss, such as that of ordinary photographs. Other people like lustreless images of the order of 50 in the terms of 75° gloss. Still others like an image of about 70 such as used in general posters. Accordingly, the thermal treating device of the apparatus of the present invention is preferably capable of varying the degree of gloss according to taste. This can be achieved by altering the conveyance speed of the sheet on which the visible image is created. The thermal treating means is preferably arranged to be easy to assemble and reliable.

In order to remove the irregularities of the surface of the sheet on which a visible image is created and to obtain a lustrous and vivid image in a short time, the thermal treating means should be able to heat the sheet rapidly.

While the sheet is being rapidly heated in a known apparatus, if the power is turned off, e.g. when the user of the apparatus operates the switch to turn off the power, a breaker opens, or a blackout takes place, and then the sheet is overheated so that it is deformed or decomposes. The material forming a visible image is then decomposed by heat, thus producing a large amount of poisonous gas. In the preferred form of the present invention, however, a safe, thermal treating means is provided which neither overheats the sheet on which a visible image is created nor produces a large amount of poisonous gas if the power is turned off during heating of the sheet.

We have found that a large amount of irratative gas is produced when images are created, thus making the user uncomfortable. In the case of the present invention, however, the said gas-removing means will prevent the user from suffering such discomfort and is safe.

As indicated above, a heater producing radiation heat may be provided, and a movable heat-insulating member may be mounted between the heater and the sheet on which a visible image is created. If the conveyance speed of the sheet is varied, an image having a desired degree of gloss can be obtained.

As also indicated above, a sheet support member may be provided which extends in a direction not parallel to the direction of movement of the sheet. In this construction, good conveyance is assured. Hence a vivid image can be obtained without producing nonuniformity in glossiness. The thermal treating device can be assembled as a unit and so the manufacturing operation can be carried out efficiently and may involve a smaller number of steps than usual. In addition, the device can be assembled accurately. Moreover, wires constituting the sheet support member can be fixed reliably. Furthermore, the thermal treating device is preferably such that it can be readily exchanged.

In another preferred feature of the invention, a heater producing radiation heat and a heat-insulating member are provided. When the power is cut off, the heat from the heater is blocked by insertion of the heat-insulating member. Therefore, during heating of the sheet, if the user turns off the power, if the breaker opens, or if blackout takes place, the sheet on which a visible image is being created is prevented from being overheated. Hence, the sheet is not scorched. Also, it is unlikely that it is deformed or decomposed by heat. Further, it is not possible that a large amount of poisonous gas is generated. In this way, the apparatus is safe.

In a further preferred feature of the invention, image quality is prevented from being adversely affected by the size of the paper, the thickness, the quality of the material, the surface roughness, the state of the photosensitive member, and the environmental conditions. When the width of the paper is changed, e.g. to A3 or A4, or when material is varied, e.g. from ordinary paper to OHP paper or vice versa, it has previously been difficult to effect development under the same pressure. In the preferred form of the present invention, however, image quality is prevented from deteriorating and jams and creases can be avoided.

In yet another preferred feature of the present invention, irritative gas produced during creation of an image can be efficiently removed. This prevents the user from feeling uncomfortable. The lower portion of the apparatus may be used for removal of the gas. Therefore, a complex exhaust duct is not required to be mounted inside the apparatus. Consequently, it is easy to make the apparatus of small size. A gas filter taking the form of a cassette can be removably inserted into the body of the apparatus. When the user exchanges the gas filter, he or she need not touch the inside of the apparatus. Thus the gas filter can be safely and easily installed and withdrawn.

In a still further preferred feature of the present invention, the apparatus can be arranged to sense whether the gas filter is new or old. The apparatus may be such that it does not operate unless a new gas filter is installed and does not operate after a predetermined number of sheets of paper have been printed. If the gas filter is mistakenly withdrawn in use, a new gas filter must be installed. Then, the number of sheets of paper is counted. If the installed gas filter is replaced with a new one before the predetermined number is reached, then the total count recorded is reset to 0. Subsequently, this new gas filter can be employed until the full predetermined number is reached. In any case, the gas filter can be prevented from being used for more than the predetermined number of sheets of paper. This gives great safety to the user. If the gas filter has an appropriate cover, when adsorbent material therein can no longer be used and should be replaced, the user can exchange it together with the cover. Therefore, oily matter adhering to the adsorbent material does not foul the user's hands. The cover may be provided with a handle to facilitate replacement. If the oily matter adhering to the adsorbent material is collected on it and drips, the cover may be such as to prevent the lower portion of the apparatus body from being directly fouled.

A gaseous component having a high boiling point and a high viscosity can be condensed and adsorbed on the bottom of the cover. The size of the adsorbent material can be reduced accordingly, or the adsorbent material can be made from a cheaper material. This greatly contributes to a reduction in the size, as well as to a reduction in the cost.

Within the duct for discharging gas, an auxiliary adsorption portion and an absorbing member may be disposed on the upstream side of adsorbent material of activated carbon or the like. This can reduce the amount of gas reaching the adsorbent material, which prevents the duct from being clogged up by the adsorbent material. Also, the lifetime of the adsorbent material is increased. It is unlikely that the oily matter which can adhere to the inner wall of the discharge duct will flow through the apparatus as a liquid and adhere to the sheet being printed. Additionally, the oily matter is prevented from leaking out of the apparatus. In this way, the user is prevented from touching the condensed gaseous component. Where an auxiliary adsorption pattern and an adsorbing member, are made from a material such as a metal plate, plastics felt, or nonwoven fabric, it is unnecessary to replace the filter.

Three parts of the image-creating apparatus will usually require to be replaced in use. In particular, two are the container holding the photosensitive member and the sheet on which a visible image is to be created. The remaining one is the gas filter which must be replaced when its life has expired. In one preferred aspect of the invention, however, the gas-removing means and the container holding the photosensitive member are combined into a unit. Thus, only two of the parts referred to above are required to be replaced. After the photosensitive member is used up, the container holding the photosensitive member is replaced. This automatically replaces the gas filter. For this reason, the life of the gas filter is matched to the number of sheets of paper that the photosensitive member can copy. In other words, in case of a single gas filter, it is required to give it a long life by making the gas filter large in order to reduce the number of times it needs to be replaced. However, by forming the gas filter integrally with the photosensitive member container it is possible to realize minitualization because there is no need to make the life of a gas filter long. Further, due to the unitary structure, the number of parts can be reduced, thereby also reducing the cost.

The invention is illustrated, merely by way of example, in the accompanying drawings, in which:-

Figure 1 is a front elevation in cross section of a first embodiment of an image-creating apparatus according to the present invention;

Figure 2 is a schematic view of a pressure-adjusting means forming one example of a development means which may be used in the apparatus of Figure 1;

Figure 3 is a graph showing the characteristic of the pressure applied by the pressure-adjusting means shown in Figure 2;

Figure 4 is a schematic perspective view of a container which is arranged to hold sheets on which visible images are to be created, the container being shaped so as to detect the size of the sheets;

Figure 5 is a schematic plan view of the container shown in Figure 4 and of a detector mounted on the container;

Figure 6 is a schematic view of a pressure-adjusting means forming another example of the development means which may be used in the apparatus of Figure 1;

Figures 7 and 8 are side elevations of the pressure-adjusting means shown in Figure 6 showing different conditions;

Figure 9 is a schematic perspective view of a thermal treating means which may be used in the apparatus of Figure 1;

Figure 10 is a perspective view of a heater producing radiation heat and a reflector which form part of the thermal treating means of Figure 9;

Figure 11 is a perspective view of a guide member which is integral with a sheet support and which forms part of the thermal treating means of Figure 9;

Figures 12(a)-12(c) are perspective views of part of the structure shown in Figure 9 and illustrating successive positions of a sheet passing thereover,

Figure 13 is a perspective view of a mechanism for driving a shutter which forms part of the said thermal treating means and which is a heat-insulating member, Figure 13 showing the position of the parts when the power is ON;

Figures 14(a)-14(c) are plan views showing the relationship between the position of the shutter and the area of the latter which is irradiated;

Figure 15 is a view similar to Figure 13, but showing the position of the parts when the power is OFF;

Figure 16 is a front elevation in cross-section of a heater producing radiation heat and of a shutter that is a heat-insulating member for showing their positional relationship, these members forming part of the thermal treating means of Figure 9;

Figure 17 is a diagram of a circuit for energizing a solenoid which may form part of the structure of Figure 15;

Figure 18 is a schematic view of a gas-removing means which forms part of the apparatus of Figure 1;

Figure 19 is a schematic perspective view of a pre-filter which may form part of the gas-removing means of Figure 18;

Figure 20 is a schematic view of another pre-filter which may form part of the gas-removing means of Figure 18;

Figure 21 is a schematic perspective view of a gas filter which may form part of the gas-removing means of Figure 18;

Figure 22 is a cross-sectional view of a gas filter having a cover different from the cover of the gas filter shown in Figure 21;

Figure 23 is a schematic view of one embodiment of a gas filter which may be used in the apparatus of Figure 1;

Figure 24 is a diagram of a circuit of another embodiment of a gas filter which may be used in the apparatus of Figure 1;

Figure 25 is a schematic perspective view of a further gas filter which may be used in the apparatus of Figure 1; and

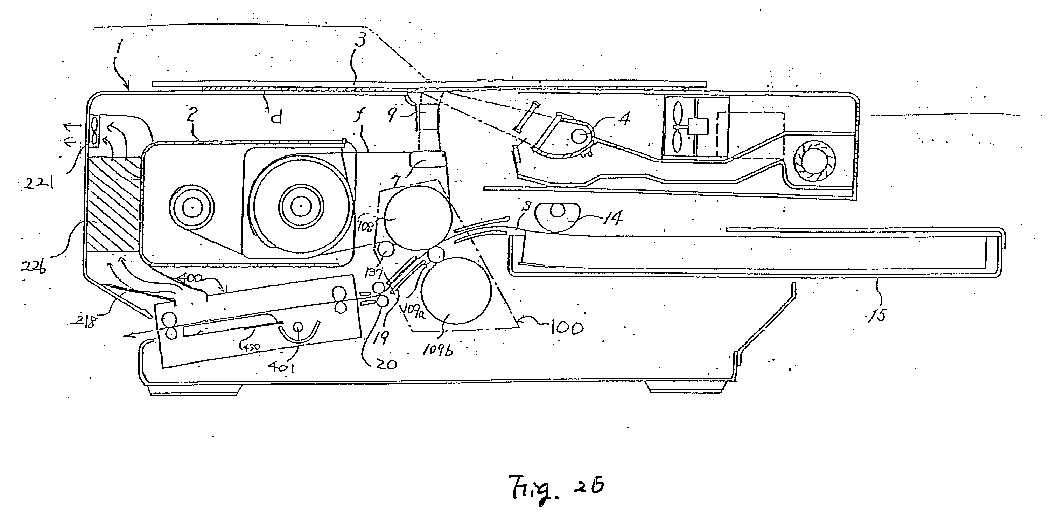

Figure 26 is a side elevation of a second embodiment of an image-creating apparatus according to the present invention.

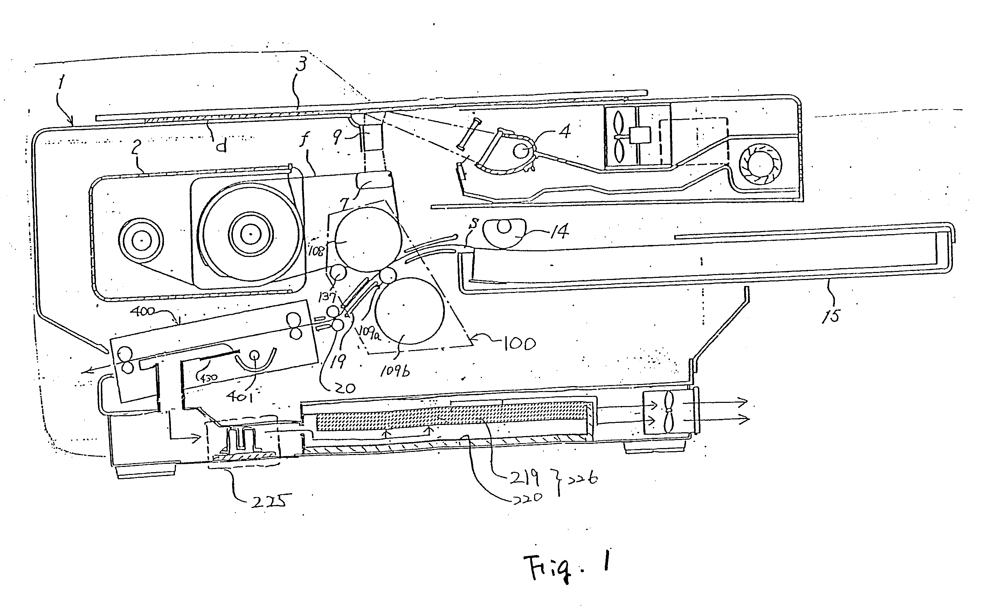

In Figure 1, there is shown an apparatus which creates an image in accordance with the invention, the apparatus having a body 1. A container 2 for holding a photosensitive member f is installed in the body 1. Microcapsules (not shown) which contain liquid colouring preforms, i.e. of cyan, magenta, and yellow, and which harden when exposed to red light, green light and blue light, respectively, are dispersed in the photosensitive member f. A document carrier 3 carries a document d and moves it in a main scanning direction, i.e. from one illustrated end to the other illustrated end. The surface of the document carrier 3 is scanned with light emanating from an exposure lamp 4 so that the document d may be exposed to the light. Light reflected from the document d is directed onto an exposure table 7 via a self-focusing lens array 9 to form a latent image on the photosensitive member f which is carried at the same velocity as the document d.

A development means 100 for making a photographic development under pressure has a pressure-adjusting mechanism. Pressure rollers 108, 109a, 109b are disposed inside the development means 100 to apply pressure to the exposed photosensitive member f and to a sheet s on which a visible image is created. The sheet s is held in a container or cassette 15 carried by a carriage roller 14. Thus, the photosensitive member f and the sheet s are pressed against each other to break those microcapsules which did not harden during the exposure step and which lie on the photosensitive member f. The liquid colouring preforms inside the broken microcapsules are transferred to the sheet s. At the same time, the colouring preforms are caused to react with developer applied to the sheet s, thus developing the colours.

A separation guide 137 is mounted on the exit side of the development means 100. The developed photosensitive film f is forced into the container 2 while guided by the separation guide 137. The sheet s which has passed through the development step passes between guide plates 19. Then, the sheet s is conveyed into a thermal treating device 400 by feed rollers 20. A heater 401 incorporated in the thermal treating device 400 heats the sheet s to promote development of the colours. Also, lustre is imparted to the surface of the image, as described below. Then the sheet s is removed. Gas produced by the thermal treating means 400 is removed by gas-removing means 225 and 226.

Development Means

The development means 100 is next described in detail.

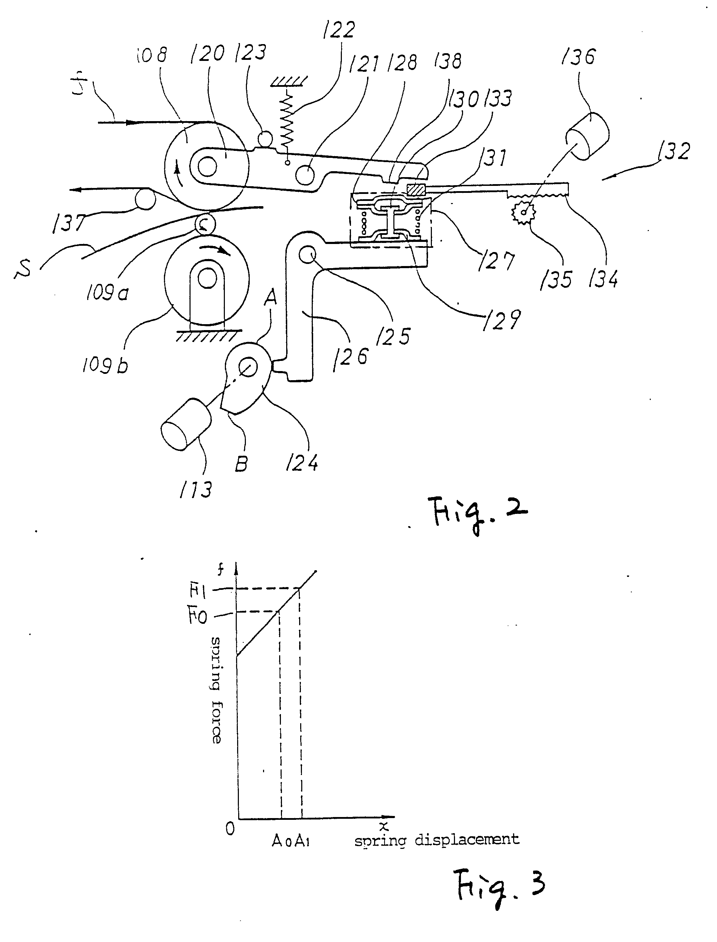

Figure 2 shows one example of the development means 100. The pressure roller 109a is supported on the backup roller 109b so as to withstand a large pressure. The backup roller 109b is rotated by a motor (not shown) in the direction indicated by the arrow. The diameter of the pressure roller 109a is made small so as to decrease the requisite pressure which needs to be applied. The other pressure roller 108 is supported on a support member 120, which is pivotally mounted at a pivot 121. The support member 120 is always biased upwardly by a weak spring 122 towards engagement with a stopper 123. A pressure adjusting device comprises a cam 124, which is directly coupled to a motor 113, and a lever 126, the latter being mounted so as to be rotatable about a pivot 125. When a portion A of the cam 124 engages the lever 126, the pressure rollers 108 and 109a are kept apart from each other. When a portion B of the cam 124 engages the lever 126, the pressure adjusting device brings the pressure rollers 108 and 109a into contact with each other. A pressure spring 127 that determines the applied force comprises an upper seat 128, a lower seat 129, a pin 130 and a coil spring 131. The spring 127 is mounted in the pressure adjusting device. The coil spring 131 is kept in compression. A spring force-adjusting device 132 comprises a slide member 134, a pinion 135, and a motor 136 for driving the pinion 135. The slide member 134 includes a front end portion 133 and a rear end portion having a rack.

Figure 2 shows the condition in which the pressure rollers 108, 109a are kept apart from each other. The photosensitive member f is wound around the pressure roller 108, passes over the separation guide 137, and is wound up inside the container 2 (Figure 1) for holding the photo-sensitive member f. In this state, the sheet s is supplied and superimposed on the photosensitive member f. At this time, the front end portion 133 of the slide member 134 can be inserted by the motor 136 between the upper seat 128 and a seat 138 of the support member 120. When it is desired to increase the applied pressure, the front end portion 133 is so inserted. Normally, however, it is not so inserted. When the cam 124 rotates and moves from a position in which the portion A engages the lever 126 to a position in which the portion B engages the lever 126, the pressure spring 127 moves upwards to elevate the seat 138 of the support member 120, so pressing the upper pressure roller 108 against the lower pressure roller 109a. The compressive force of the pressure spring 127 urges the sheet s against the photosensitive member f, thus making a photographic development. The development gradually progresses as the rollers 108 and 109a rotate. The applied force can be switched between two values by inserting or not inserting the front end portion 133 of the slide member 134, i.e. by moving the point at which the pressure spring 127 acts either onto the front end portion 133 or onto the seat 138 of the support member 120. Where two kinds of sheets of paper having different widths, such as the A4 size and a smaller size, are used as sheets on which visible images are to be created, the applied force is increased for the A4 size and is not increased for the smaller size during the development.

Figure 3 is a graph showing the characteristic of the spring 127. In this graph, the force of the spring 127 is plotted against the displacement of the spring. Usually, the spring 127 is kept in compression. The cam 124 applies a force to the spring 127 until it is displaced to a position Ao. In this state, the spring 127 exerts a force of Fo. When the front end portion 133 of the slide member 134 is inserted, the spring 127 is displaced by the thickness of the front end portion 133. As a result, the spring 127 is displaced to a position $A_1$, and produces a force $F_1$.

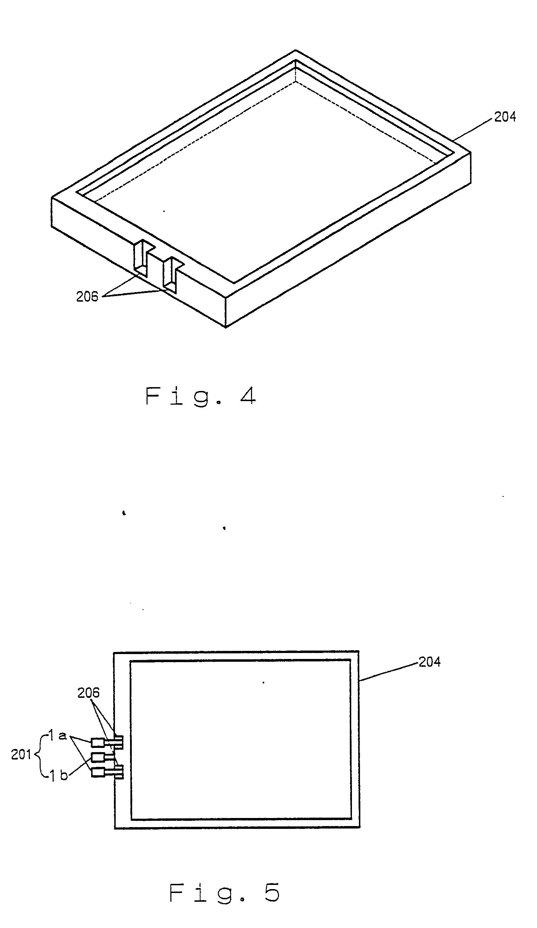

If the size of the sheet s is known, it is advantageous. That is, if there is a means of detecting the size of the sheet s on which a visible image is to be created, it is advantageous. The side surface of the container 15 for holding the sheet s can be shaped so as to detect the size. Figure 4 is a perspective view of a sheet-holding container 204 having a size-detecting portion 206. Figure 5 is a schematic plan view of the container 204 having the detecting portion 206. The container 204 is installed in the image-creating apparatus. The apparatus comprises a detector 201 which consists of sensors 1a and 1b. The output signal from the sensors 1a, which are disposed opposite to recesses in the detecting portion 206, is OFF. The output signal from the sensor 1b which is opposite to a flat wall surface is ON. The container 204 is provided with the detecting portion 206 and various other portions to detect sizes. In this way, the detector 201 can detect the sizes of a plurality of differently sized sheets.

Referring back to Figure 2, when the size of the sheet s is detected, the motor 136 is driven (by means not shown) to optimize the pressure applied by the development means 100 according to the said size. This enables the development means 100 to provide an image of the best quality.

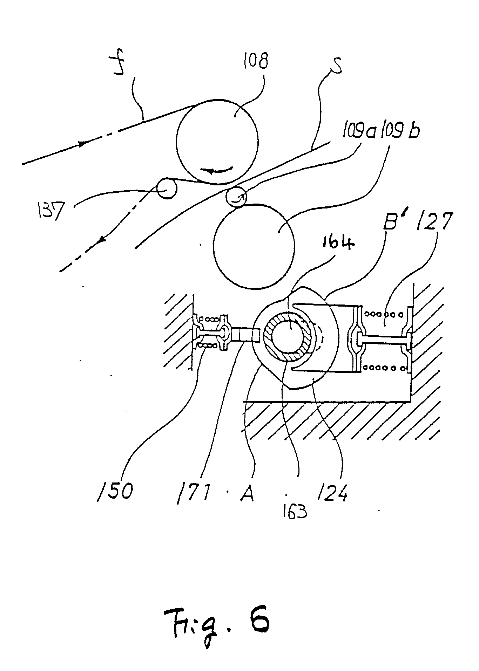

Figure 6 shows another embodiment of the development means. A cam 124 has a shaft 164 which is mounted in a bearing 163. As a motor (not shown) rotates, the cam 124 rotates so that its surface B bears against a back-up roller 109b, so' bringing the pressure roller 109a into contact with the other pressure roller 108. Then, the compressive force of a pressure spring 127 presses the sheet s against the photosensitive member f, thus making a photographic development.

In order to change the force exerted between the pressure rollers 108 and 109a, the force applied to the cam shaft 164 by a second pressure spring 150 is varied, because the force exerted between the rollers 108 and 109a is determined by the difference between the forces applied to the cam shaft 164 by the springs 127 and 150, respectively.

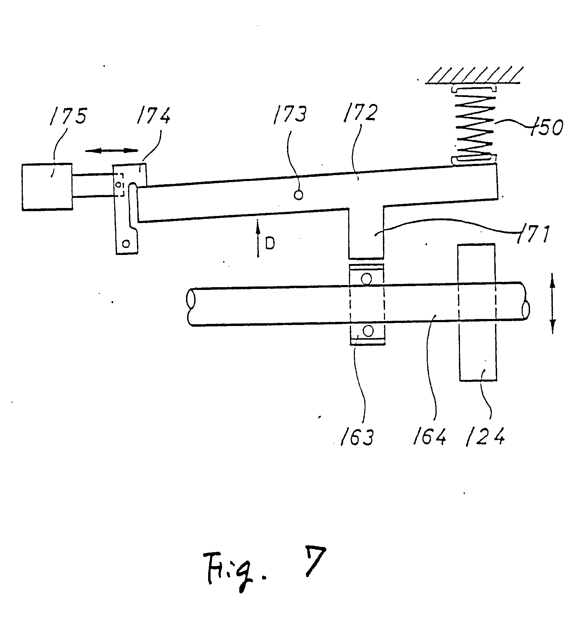

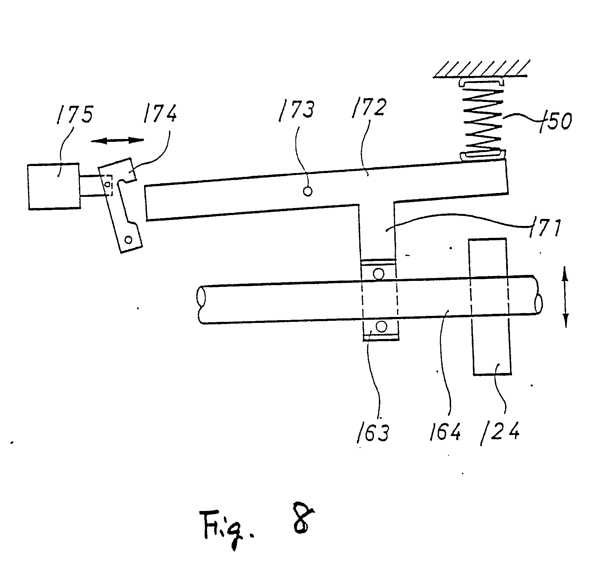

A means for varying the force applied to the cam shaft 164 by the second pressure spring 150 is shown in Figures 7 and 8. Figure 7 shows a condition in which the second pressure spring 150 applies a small force to the cam shaft 164. Figure 8 shows a condition in which the spring 150 exerts a large force on the shaft 164.

In the condition of Figure 7, a lever 172, which is pivoted at 173, is caused to engage with a stopper 174. In this state, the force of the second pressure spring 150 is not transmitted to the cam shaft 164. Therefore, the pressure roller 109a shown in Figure 6 is pressed against the pressure roller 108 with a large force.

In the condition of Figure 8, a solenoid 175 is energized to attract the stopper 174 and thus release it from the lever 172. The force of the pressure spring 150 is transmitted to a protrusion 171 via the lever 172. The protrusion 171 presses against the bearing 163, so that the force of the spring 150 is transmitted to the cam shaft 164. Therefore, the roller 109a is pressed against the roller 108 with a small force in the condition shown in Figure 6.

When the stopper 174 is so attracted, the protrusion 171 bears on the bearing 163, creating a gap between the lever 172 and the stopper .174. Since no force is applied to the stopper 174, an actuator 175 consisting of only a small solenoid or the like is sufficient to attract the stopper 174. The applied force can be easily switched between two values. The second pressure spring 150 can be used at a position in which it acts in the direction indicated by an arrow D in Figure 7. In this case, the lever 172 rotates about the pivot 173. The force of the spring 150 is transmitted via the protrusion 171. It is possible to fabricate the spring 150 in a small size.

As shown in Figures 4 and 5, the container 204 for holding the sheets s on which visible images are to be created has the portion 206 for detecting the size of the sheets. By providing the sheet-holding container 204 in the image-creating apparatus, the size of the sheet s can be detected. As indicated above, the solenoid shown in Figures 7 and 8 is energized to drive the stopper 174. varying the pressure applied by the development means 100. This enables the development means 100 to provide the best image quality.

Thermal Treating Means

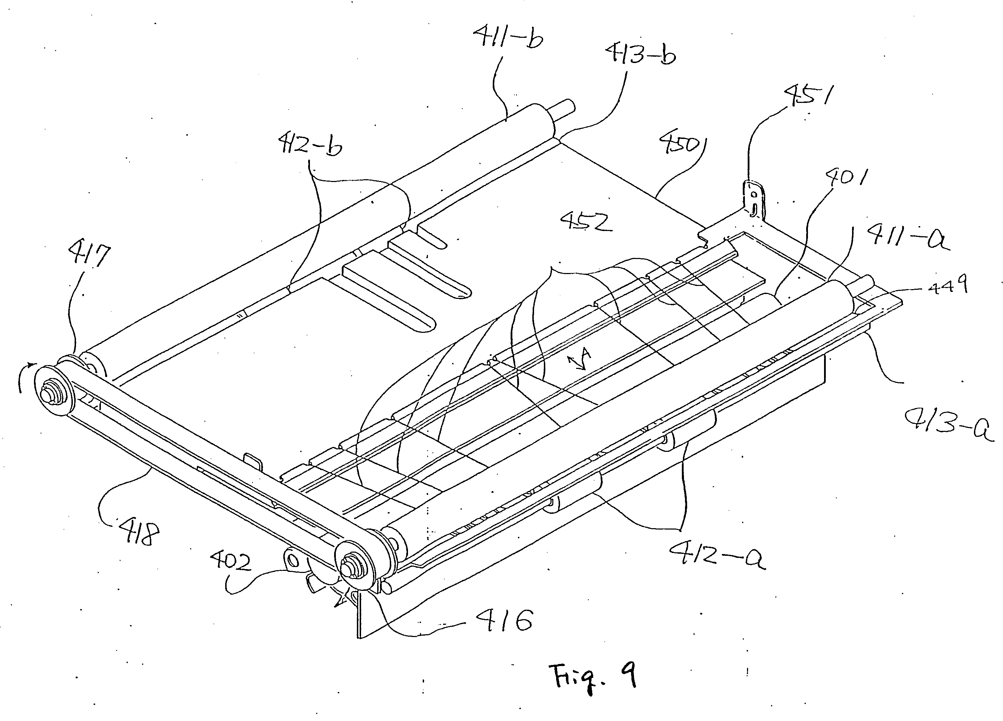

Figure 9 is a schematic perspective view of the thermal treating means 400. A rubber roller 411-a disposed near the entrance to the thermal treating means 400 comprises a roll of silicone rubber mounted on a shaft made of free-cutting steel. Backup rollers 412-a made of a polyacetal are fixed to a backup roller 413-a by an E-shaped retaining ring (not shown), the roller 413-a being made of free-cutting steel. The back-up rollers 412-a are pressed against the roller 411-a by a spring (not shown). Similarly, a rubber roller 411-b, backup rollers 412-b, and a backup roller shaft 413-b are disposed on the exit side of the thermal treating means 400. A pulley 417 on the exit side is fixed to the rubber roller 411-b by an E-shaped retaining ring and a spring pin (not shown). A pulley 416 on the entrance side is fixed to the rubber roller 411-a by an E-shaped retaining ring and a spring ring (not shown). Rotating the roller 411-b turns the pulley 417 on the exit side. The power is transmitted to the pulley 416 on the entrance side by a timing belt 418. The pulley 416 on the entrance side rotates the rubber roller 411-a on the entrance side.

An entrance paper guide 449 made of plated steel is mounted below the rubber roller 411-a on the entrance side. The guide 449 also acts to guide the sheet and a wire 452 made of piano wire or stainless steel. The wire 452 serves to support the sheet. As shown in Figure 9, the wire 452 is guided by grooves formed in a wire guide 451. A paper guide 450 made of heatproof resin is disposed below the wire guide 451, and acts to guide the sheet s until it reaches the rubber roller 411-b on the exit side and the backup rollers 412-b.

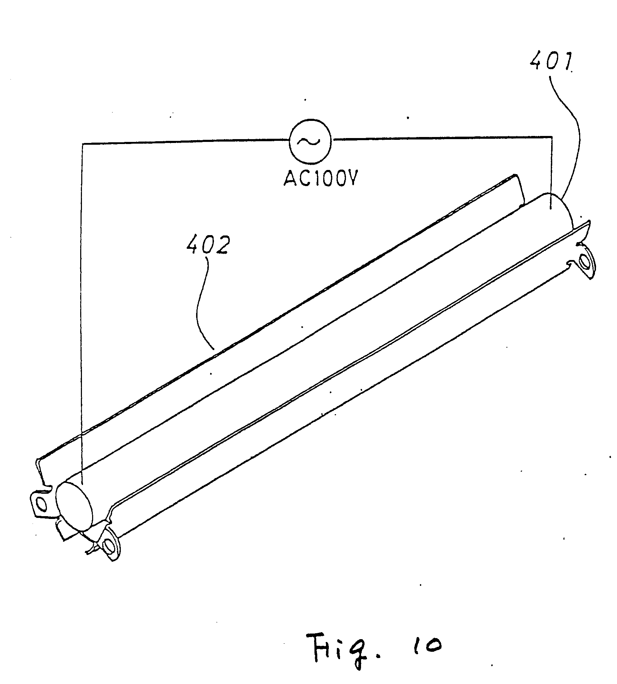

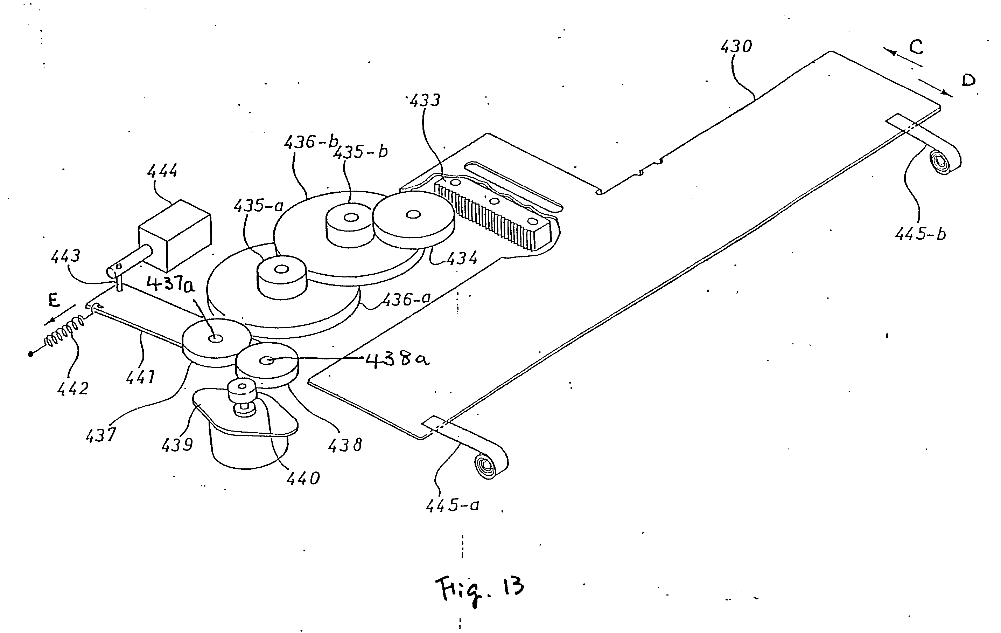

Mounted below the paper guide 450 is a shutter 430 (Figure 13) made of a cold-rolled steel plated with nickel. The shutter 430 functions as a heat-insulating member and can be moved in the direction indicated by an arrow c. A rodlike ceramic heater 401, which emits far-infrared radiation, and a reflector 402 are located below the shutter 430. The reflector 402 is made of an aluminium alloy or stainless steel. The construction of the heater 401 and of the reflector 402 is shown in Figure 10. An AC voltage of 100 V is applied to the heater 401. The ceramic heater 401 producing radiation heat can be replaced with a far-infrared heater using a quartz glass tube or a halogen heater.

The sheets on which a visible image is to be created is heated by radiation heat, i.e. in a non-contact manner. This is desirable because, during heating, the colour formers and the developer on the sheet are melted. If they come into contact with the image surface, the image quality deteriorates.

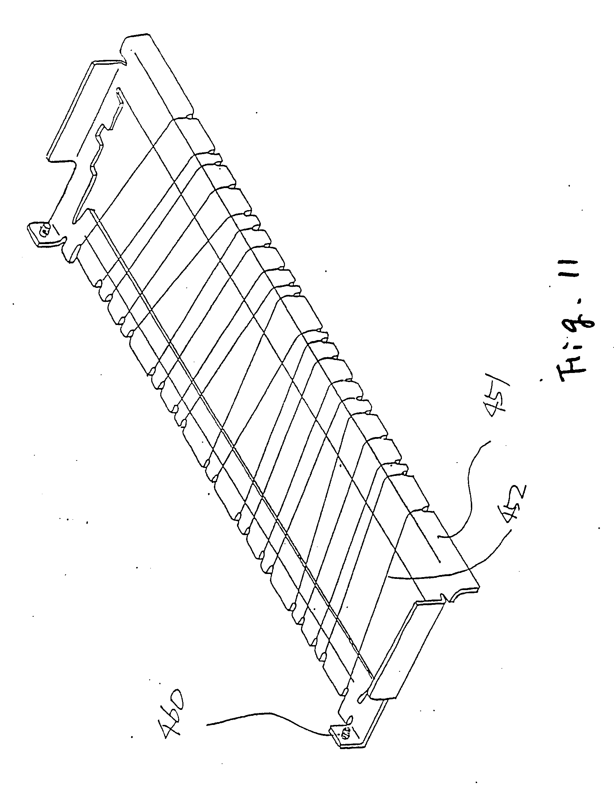

Figure 11 is a perspective view of the wire guide 451 which forms or is integral with a sheet support. The wire guide is provided with the wire 452. Opposite ends of the wire 452 are fixed to the wire guide 451 by wire retainers 460, such as screws, formed integrally with the wire guide 451. The wire 452 acts to guide the sheet. Thus, the sheet support is easy to assemble as a unit, and the wire 452 is fixed reliably thereto. Also, the thermal treating device 400 can be easily assembled. In addition, the said sheet support can be designed so that it can be readily replaced.

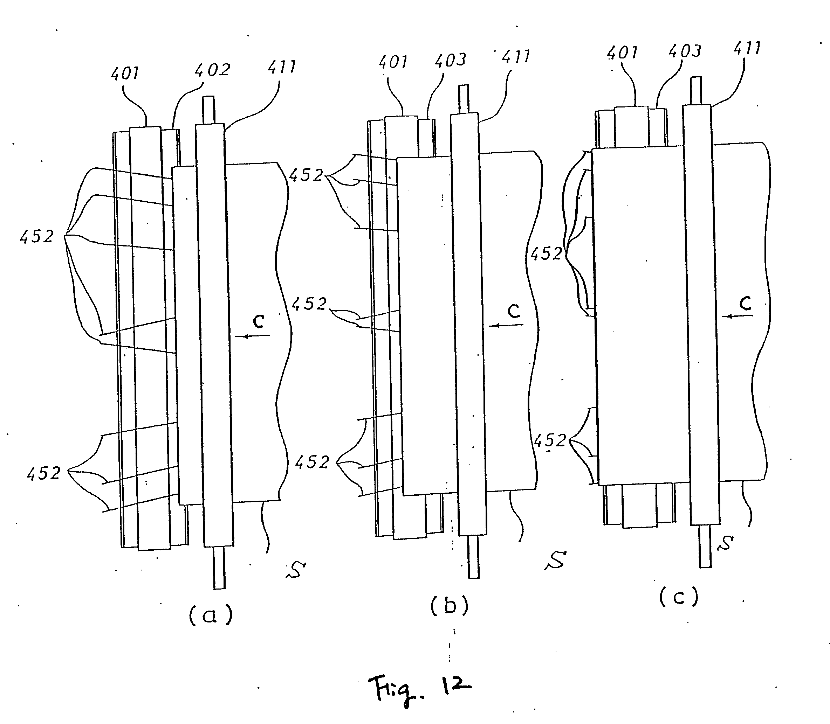

The heating process carried out by the structure described above is as follows. Referring back to Figure 9, the sheet s which was developed under pressure is conveyed onto the entrance paper guide 449 and then moved onto the wire 452 by the rubber roller 411-a and the backup rollers 412-a, the rubber of the roller 411-a being silicone rubber. The wire 452 is oriented so as not to be parallel to the direction of movement of the sheet s. The direction in which the wire is stretched is shown in Figure 12. The sheet s is transported in the direction indicated by the arrow C.

That is, it is carried as shown successively in Figures 12(a), 12(b) and 12(c). The direction in which the wire 452 extends is not parallel to the direction of movement of the sheet for the following two reasons. First, if the wire 452 extends parallel to the direction of movement of the sheet, then the sheet s is heated by the radiation heat from the heater 401 from below the sheet. This creates shadows of the wire, rendering the lustre non-uniform. Another reason is that if the sheet is heated its rigidity is lost, and both ends of the sheet drop. As a result, the paper tends to jam. Where the wire 452 is stretched as shown in Figures 12(a)-12(c), both ends of the sheet are supported. Therefore, the risk of paper jams is reduced. No shadows of the wire 452 are produced. Hence, a vivid image free of non-uniform lustre can be obtained. The sheet s is heated from below it, i.e. from the rear side of the image surface, to obtain a lustre independent of the hues on the image surface.

The construction of the mechanism driving the shutter 430 is next described. Figure 13 is a perspective view of this mechanism, and in which the power is ON. A rack 433 made of brass is screwed to the underside of the shutter 430. A gear 434 having 34 teeth and made from heatproof resin is in mesh with the rack 433. In the present example, polyphenylene sulphide is used as the heatproof resin. A gear 435-b having 19 teeth is in mesh with the gear 434. The gear 435-b is moulded integrally with a gear 436-b having 79 teeth. These gears are made from polyphenylene sulphide resin in the same way as the gear 434. A gear 435-a is in mesh with the gear 436-b. The gears 435-a and 436-a are similar to the gears 435-b and 436-b respectively. A gear 437 having 55 teeth and made from heatproof resin is in mesh with the gear 436-a. A gear 438 having 29 teeth is in mesh with the gear 437. A pinion 440 which has 17 teeth and is mounted on the shaft of a stepper motor 439 is in mesh with the gear 438. Consequently, the number of revolutions made by the motor 439 is reduced by a factor of about 35, and the gear 434 is rotated. Then, the rack 433 is driven to move the shutter 430 into a desired position either in the direction indicated by the arrow C or in the direction indicated by the arrow D.

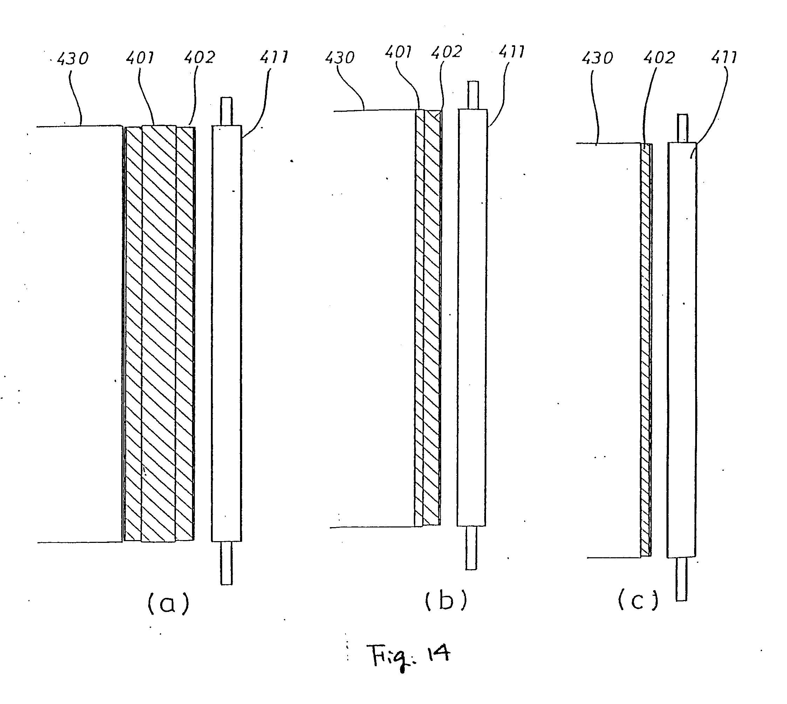

Figures 14(a)-14(c) show the relationship of the position of the shutter 430 to the area of an illuminated or heated portion thereof. In these figures, the said illuminated portion is indicated by hatching. When an image of a low gloss is desired, the shutter is moved as shown in Figure 14(c) to reduce the area of the illuminated portion, thus decreasing the amount of heat applied to the sheet.

When a medium gloss is desired, the shutter 430 is moved to increase the area of the illuminated portion, as shown in Figure 14(b). When the greatest degree of gloss is desired, the shutter is moved into the position shown in Figure 14(a) to maximize the area of the illuminated portion, thus maximizing the amount of heat applied to the sheet. In this way, an image having a desired degree of gloss can be obtained by moving the shutter.

The velocity at which the sheet can be conveyed through the apparatus described above can be changed to 5 mm/s, 7 mm/s, 9 mm/s. 11 mm/s, 13 mm/s. 15 mm/s, and 17 mm/s. It is thus possible to obtain images of a desired degree of gloss by changing the position of the shutter 430. In particular, gloss values of 50, 60, 70, 80 and 90 can be derived depending on the conveyance velocities.

Spiral springs 445-a and 445-b are fixed to the shutter 430 at opposite sides to apply a force which is directed in the direction indicated by the arrow D at all times. The force with which the shutter 430 is pulled by the springs 455-a and 445-b in the direction indicated by the arrow D is larger than the frictional force that the shutter 430 encounters. Since the stepper motor 439 produces friction when it is at rest, if the shutter 430 is always pulled in the direction indicated by the arrow D, the shutter 430 does not move. The shutter 430 can be moved into an arbitrary position and retained there by the motor 439. The spiral springs 445-a and 445-b are used to pull the shutter 430 in the direction indicated by the arrow D. The reason why spiral springs are used is that this can move the shutter 430 with a constant load irrespective of the position of the shutter 430.

If general coiled springs are employed, the shutter cannot be moved with a constant load.

The gears 437 and 438 are fixed to respective shafts 437a, 438a by E-shaped retaining rings (not shown). The shafts 437a, 438a are crimped against a lever 441 made of plated steel which is rotatable about the axis of the shaft 438a. Thus the gear 437 can rotate around the gear 438, i.e. the gear 437 acts as a planetary gear. A coiled spring 442 is fixed to the lever 441. A solenoid 444 is coupled to the lever 441 via a pin 443. The solenoid 444 may be either a normal solenoid or a keep solenoid.

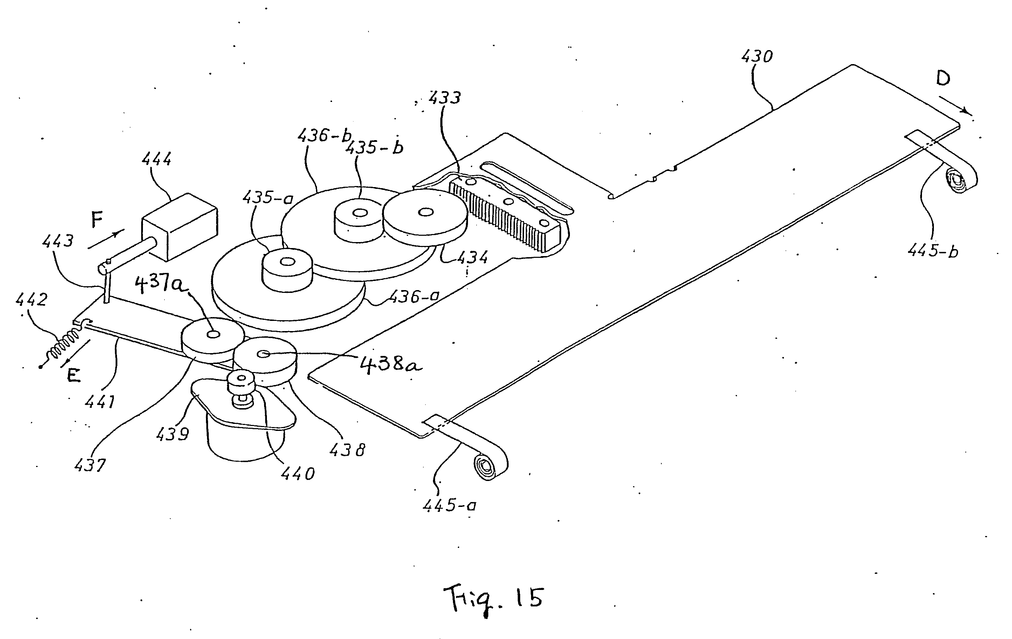

An embodiment in which the solenoid 444 is a normal solenoid is next described. Figure 15 is a perspective view of a device for driving the shutter 430, the parts being shown in their positions in which the power is OFF. In this state, the solenoid 444 produces no force of attraction and so the coiled spring 442 pulls the lever 441 in the direction indicated by the arrow E. The lever 441 and the gear 437 revolve around the gear 438, and the gear 437 is spaced from the gear 436-a. Consequently, the frictional force of the motor 439 that is at rest cannot hold the shutter 430 at rest. The spiral springs 445-a and 445-b pull the shutter 430 in the direction indicated by the arrow D to close the shutter 430.

When the power is turned on, a DC voltage of 24 V is applied to the normal solenoid 444 to thereby energize it. The solenoid 444 attracts the lever 441 in the direction indicated by the arrow F, so moving the lever 441. This brings the gear 437 into mesh with the gear 436-a, whereby the condition shown in Figure 13 is obtained. If a DC voltage of 24 V is kept applied to the solenoid 444, then the solenoid 444 will overheat. In the present example, after a DC voltage of 24 V is applied for 0.2 second, only a DC voltage of 5 V is applied to the solenoid 444. Once the solenoid 444 attracts the lever 441, only a DC voltage of 5 V suffices to bring the gear 437 into mesh with the gear 436-a. Then, the stepper motor 439 can place the shutter 430 in a desired position.

In the condition shown in Figure 13, when the power is turned off, the normal solenoid 444 no longer produces a force of attraction. Then, the coiled spring 442 pulls the lever 441 in the direction indicated by the arrow E. The gear 437 is moved away from the gear 436-a, so that the condition shown in Figure 15 is obtained. In this condition, the static friction of the stepper motor 439 is not capable of holding the shutter 430 at rest. The spiral springs 445-a and 445-b urge the shutter 430 in the direction indicated by the arrow D to close the shutter 430.

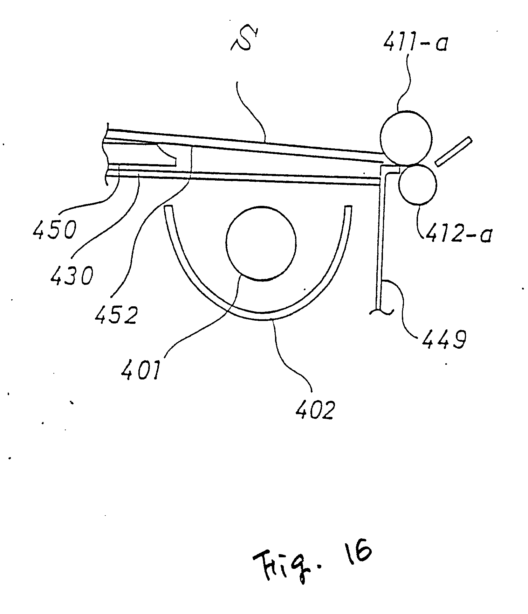

Figure 16 is a front elevation in cross section showing the positional relationship between the heater 401 and the shutter 430 which acts as a heat-insulating member. In the structure shown in Figure 16, if the power should be turned off while the heater 401 is heating the sheet s, then the shutter 430 is inserted between the heater 401 and the sheet s. Then, the shutter 430 cuts off the heat transmitted from the heater 401 to the sheet s. Therefore, it is unlikely that the sheet will be overheated or scorched. Also, it is unlikely that it will be deformed or decomposed by heat.

An embodiment in which the solenoid 444 is a keep solenoid is next described by referring back to Figure 15. When the power is turned on, a DC voltage of 24 V is applied to the keep solenoid 444 for 0.2 second. The solenoid 444 is energized to attract the lever 441 to bring the gear 437 into mesh with the gear 436-a, thus obtaining the condition shown in Figure 13. Since the solenoid 444 is a keep solenoid, after a DC voltage of 24 V is applied for 0.24 second, the gear 437 is maintained in mesh with the gear 436-a without applying voltage to the solenoid. When the power is turned on, an electric charge is stored in a capacitor (not shown in Figure 15).

When the power is turned off, the electric charge is released from the capacitor to apply a voltage to the solenoid 444 in a direction opposite to the direction of the voltage applied when the power is turned on. Then, the coiled spring 442 pulls the lever 441 in the direction indicated by the arrow E, moving the gear 437 away from the gear 436-a. Thus, the condition shown in Figure 15 is obtained. The coiled springs 445-a and 445-b close the shutter 430.

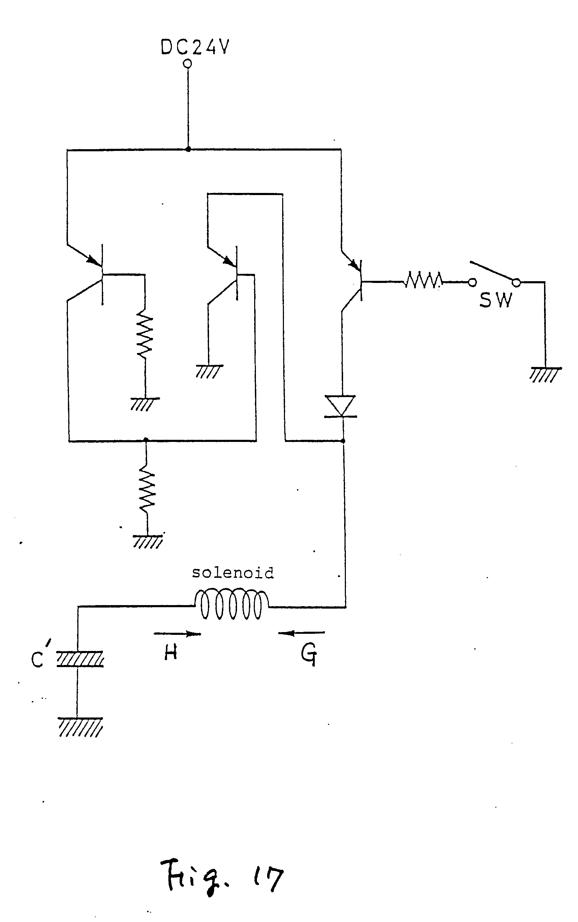

Figure 17 shows a circuit for energizing a solenoid 444 that is a keep solenoid. When the power is turned on, a switch SW is closed to cause electric current to flow in the direction indicated by the arrow G. An electric charge is stored in a capacitor C . When the power is turned off, the direct current changes from 24 V to 0 V. Then, an electric charge is released from the capacitor C , so that electric current flows in the direction indicated by the arrow H.

Gas-Removing Means

We have found that during the process of making an image, gas is produced which is unpleasant for those using the apparatus. The main components of the gas are formaldehyde, octylphenol, and gaseous substances which are produced by heating acrylic organic compounds which are contained in the photosensitive material and which have high boiling points.

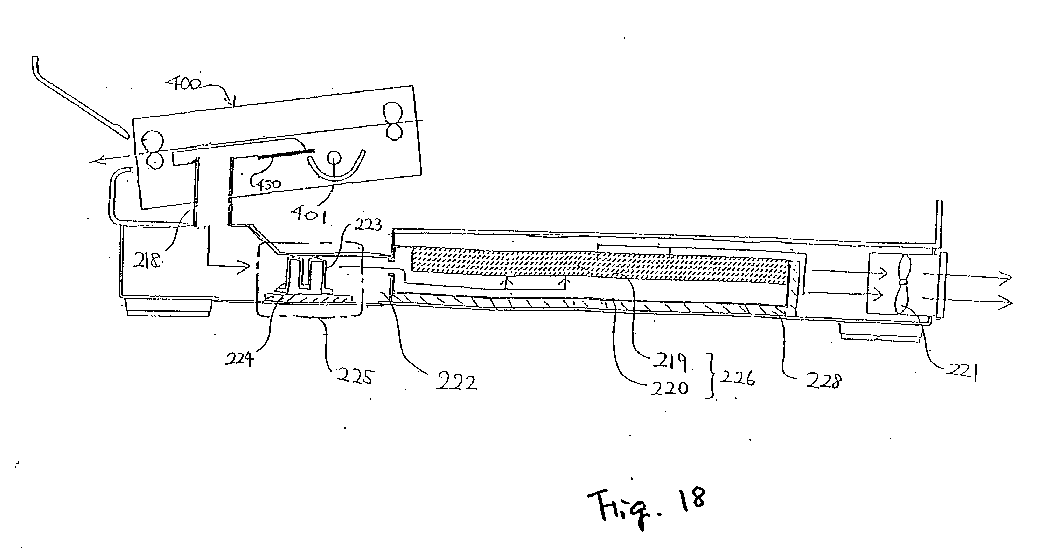

It has been found that if the image-creating apparatus is used for a long time in a closed room, the atmosphere in the room may become unpleasant. A method of removing such gas is therefore next described with reference to Figure 18, which is a schematic view of the gas-removing means 225, 226 shown in Figure 1.

Referring to Figure 18, the gas generated inside the thermal treating means 400 is drawn into an exhaust duct 222 through a guide duct 218 by an exhaust fan 221. The exhaust duct 222 is mounted in the lower portion of the apparatus. The gas is then adsorbed on a pre-filter 225 and on an adsorber 219 which are mounted inside the exhaust duct 222. The pre-filter 225 consists of an auxiliary adsorbing portion 223 and an absorbing member 224.

The aforementioned gaseous components are adsorbed in the manner described below. The auxiliary adsorbing portion 223 of the pre-filter 225 is disposed on the upstream side of the adsorber 219 and consists of a punched metal sheet. As the gaseous components pass over the punched metal sheet 223, gaseous components of higher boiling points are cooled, producing oily substances which adhere. As the amount of the adhering substances increases, the oily substances become liquid, drip, and are absorbed by the absorbing member 224 disposed below the punched metal sheet 223. The absorbing member 224 is made of felt.

The gas which has passed through the pre-filter 225 is forced into a gas filter 226 which comprises the adsorber 219 mounted in a cover 220. In the gas filter 226 the aforementioned formaldehyde, octylphenol, and other gaseous components giving off foul odours are adsorbed on the adsorber 219 which consists of activated carbon or the like.

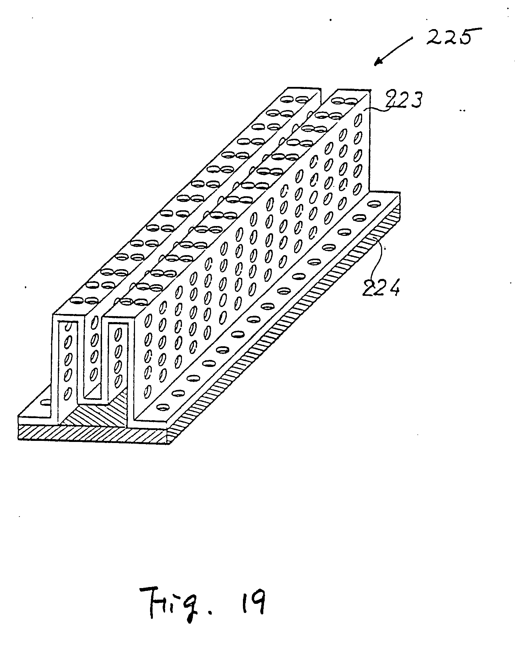

The construction of the pre-filter 225 is now described. Figure 19 is a schematic perspective view of the pre-filter 225. The punched metal sheet 223 is bent to form the auxiliary adsorber. The felt 224 acting as an absorbing member is attached to the underside of the punched metal sheet 223. The felt 224 prevents the oily matter adhering to the auxiliary adsorbing portion inside the gas exhaust duct 222 from dripping and flowing out.

In the present embodiment, the punched metal sheet 223 is bent to form the auxiliary adsorbing portion. However, the punched metal sheet can be bent arbitrarily. Also, it is possible to fabricate the auxiliary adsorbing portion from paper, plastics, cloth, ceramic, glass, or other material. Further, the absorbing member may be made from paper, sponge, cloth, or other material, as well as felt.

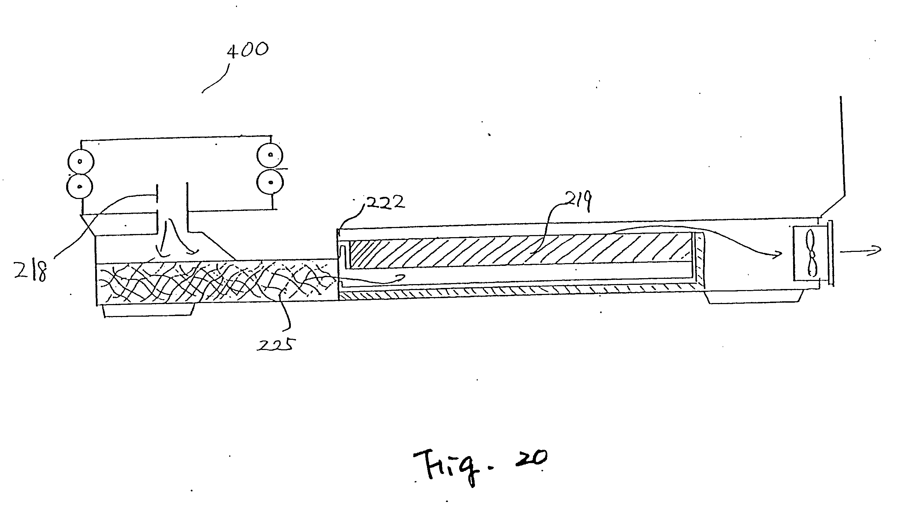

Another embodiment of the pre-filter is shown in Figure 20. In this case, the pre-filter 225 takes the form of a pad which is disposed inside the gas exhaust duct 222 on the upstream side of the adsorber 219. In this embodiment, the pre-filter 225 also functions as the above-described auxiliary adsorbing portion and absorbing member. The material can be unwoven fabric, sponge, chemical fibres, steel fibres, porous paper or cloth, if its resistance to gas is such that the flow velocity inside the gas exhaust duct 222 is maintained constant, and if its contact area with the gas is large.

The adsorber 219 that most effectively removes the components of the produced gas and the foul odours consists of activated carbon or the like. Since the adsorber has a limited life, whenever a predetermined number of sheets of paper are printed, the adsorber 219 is required to be replaced. An installation structure for replacing the gas filter 226 is next described.

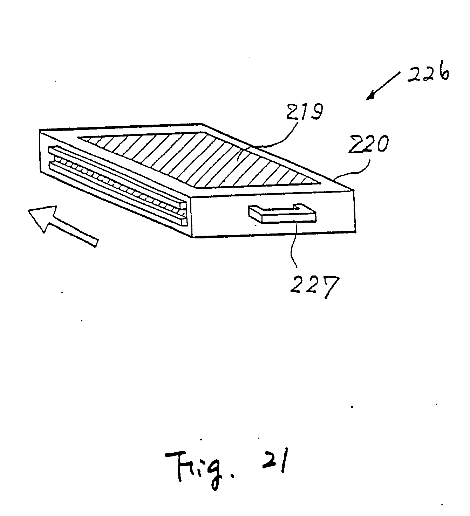

Figure 21 is a perspective view of the gas filter 226. This filter is in the form of a cassette in which the adsorber 219 is integral with the cover 220. When the filter is operated in the direction indicated by the arrow, the gas filter 226 is installed in the body by a gas filter retainer 228 (Figure 18) mounted in the body 1. The gas filter 226 can be withdrawn from the body 1 by pulling a handle 227 in a direction opposite to the direction indicated by the arrow. In this way, the gas filter 226 can be replaced from outside the apparatus. Hence, the user can easily and safely replace it.

Since the cover 220 forms part of the gas filter 226, the gaseous components which have high boiling points and were not adsorbed on the pre-filter 225 adhere as oily matter to the entrance of the adsorber 210 (Figure 18) and to the bottom plate of the cover 220. The cover 220 is a metal member mounted on the adsorber 219 to prevent the hands of the user of the apparatus from being fouled during replacement of the adsorber 219. Also, the cover 220 prevents the lower portion of the apparatus and the surroundings of the adsorber 219 being fouled due to adhesion of the oily matter.

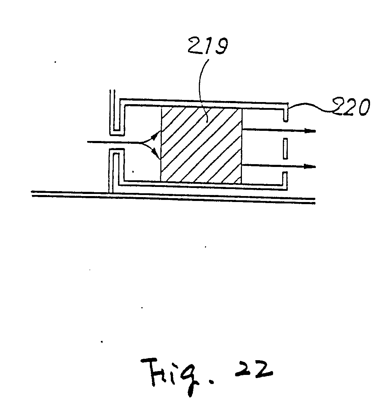

Figure 22 shows another embodiment of the cover 220 on the adsorber 219, and in which the whole adsorber 219 is enclosed in the cover 220. In the Figure 22 construction, air containing the gaseous components produced inside the apparatus enters the adsorber 219 from one side surface of the adsorber 219 and leaves it from the opposite side surface. The gaseous components of the oily matter consisting of the aforementioned liquid acrylic organic compounds of high viscosity adhere to the entrance side surface of the adsorber 219. Since the whole adsorber 219 is enclosed in the cover 220, the user can replace the filter without looking at the adsorber 219 itself. Means are described below for monitoring the state of the gas filter 226 to ensure that the user can replace the gas filter 226 safely.

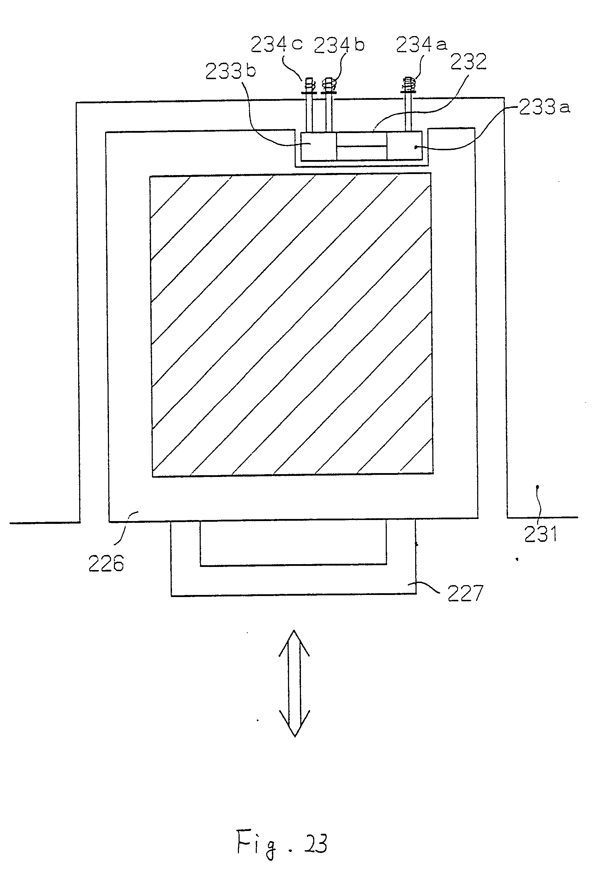

Figure 23 is a schematic view of one embodiment of the gas filter, and in which the filter includes a fuze as its operating portion. The gas filter 226 can be installed in or removed from a housing 231 by sliding the gas filter 226 in a direction indicated by the double-headed arrow in Figure 22. A fuze 232 having a glass tube is disposed behind the filter 226. Three contact springs 234a, 234b, 234c are disposed adjacent the junction between the housing 231 and the fuze 232 to make electrical connection with contacts 233a and 233b of the fuze 232. A first contact spring 234a is in contact with the contact 233a of the fuze 232. Second and third contact springs 234b and 234c, respectively, are in contact with the contact 233b of the fuze.

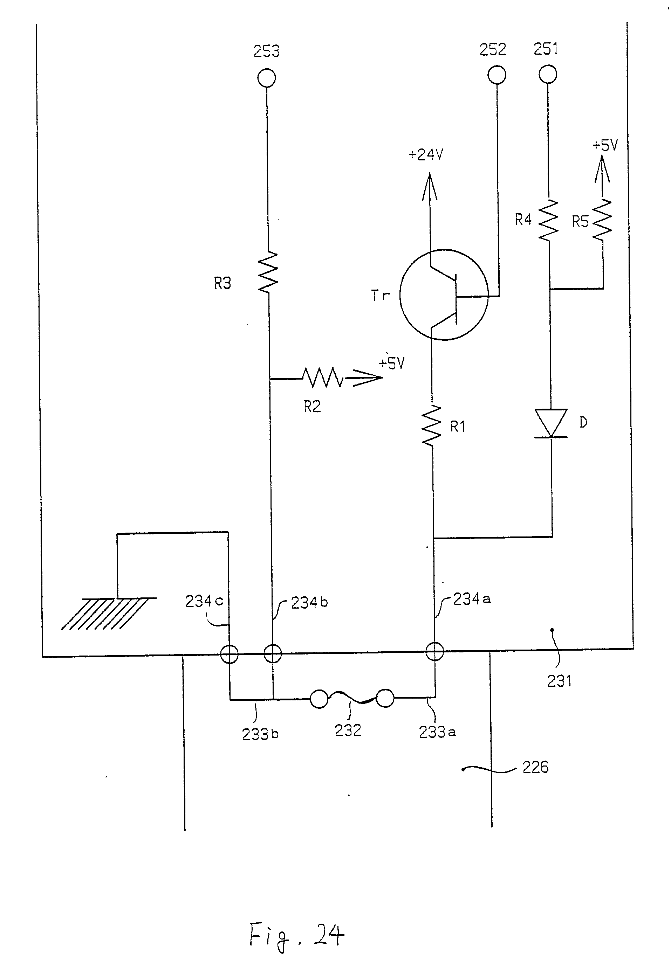

The gas filter is designed as described above. Figure 24 is a diagram of a circuit showing one embodiment of the filter. The gas filter 226 which is mounted in the housing 231 is monitored in the manner described below. When the filter 226b is placed in position, the contact 233b of the fuze 232 comes into contact with the contacts 234b and 234c, so that an electric short circuit takes place. Then, the voltage on a setting detection portion 253 in the housing 231 drops from 5 V to 0 V. In this way, the setting of the filter 226 in position is detected.

Then, a decision is made as to whether the gas filter 226 which has been found to be placed in position as described above is new or old. For this purpose, a decision is made as to whether the fuze 232 is connected or melted. If the filter 226 is new, the fuze 232 is connected in the circuit. In this state, the contacts 234a and 234c are short-circuited. The voltage on a sensing portion 251 is 0 V. This indicates that the filter 226 is new.

If the filter 226 is found to be new, a transistor Tr conducts, causing a large current to flow through the fuze 232. As a result, the fuze 232 is melted. The contact 234a of the fuze 232 is therefore disconnected from the contact 233b. The voltage on the sensing portion 251 increases to 5 V, which indicates that the gas filter 226 presently being used is old.

When the gas filter 226 is found to be new, a counter (not shown) incorporated in the housing 231 is reset simultaneously with the melting of the fuze 232. The counter then begins to count from 0. This counting operation is continued until a number predetermined for the filter is reached, whereupon the apparatus does not operate even if the copy button is depressed.

The counter is reset by placing a new gas filter 226 in position. Then, the apparatus is allowed to make copies. In this manner, the apparatus is enabled to make copies only when the gas filter 226 is found to be placed in position and when the total count obtained by the counter is less than the predetermined number. Hence, the construction ensures safe operation.

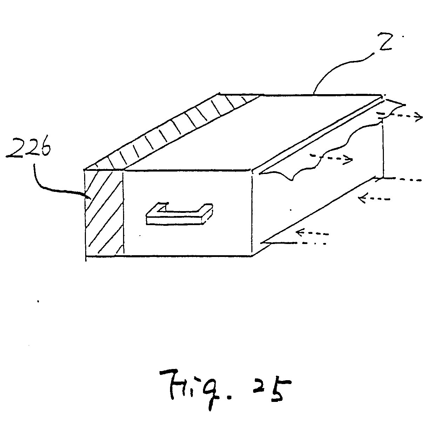

Figure 25 is a schematic perspective view of a further embodiment in which the photosensitive container 2 is integral with the gas filter 226. In the present embodiment, the photosensitive member f that is consumed is made integral with the gas filter. The life of the gas filter is designed to be identical with the life of the photosensitive member. Therefore, both parts can be replaced at the same time; heretofore they would have been replaced separately. Further, it is not necessary to install a life detector on the gas filter. When the photosensitive member f is used up, the duplication operation is automatically disabled. Consequently, the gas filter 226 is necessarily replaced.

The gas filter can be attached with screws or adhesive. In the present embodiment, the gas filter is disposed alongside the container 2 for holding the photosensitive member f. Obviously, it can also be disposed above, below, before, or behind the container 2.

Figure 21 is a schematic view of an image-creating apparatus which is provided with the above-described photosensitive container including the gas filter. The gas produced inside the thermal treating means 400 is forced by an exhaust fan 221 into the gas filter 226 through the guide duct 218 mounted over the thermal treating means 400. The gas filter 226 contains an adsorbing material such as activated carbon. When air containing the gas passes through the filter 226, the gaseous components are adsorbed on the filter 226. The result is that purified air is emitted from the apparatus. The filter 226 can be located either in front of the exhaust fan 221 or behind it.

## Claims

1. An image-creating apparatus comprising a container (2) for holding a photosensitive member (f) provided with a plurality of microcapsules containing at least a colour former and a material which hardens or softens when exposed to light; an exposure means (7,9) which exposes the photosensitive member (f) to an optical image; a container (15) for holding a sheet (s) on which a visible image is to be created; development means (100) in which the photosensitigve member (f) and the sheet (s) are superimposed and in which the sheet (s) is developed under pressure; and thermal treating means (400) for thermally treating the developed sheet (s).

2. An image-creating apparatus as claimed in claim 1 characterised in that the development means (100) comprises pressure rollers (108,109a,109b) and pressure adjusting means (113,124,126,127,132) for adjusting the pressure applied by the pressure rollers (108,109a,109b).

3. An image-creating apparatus as claimed in claim 2 characterised in that the pressure adjusting means comprises a pressure spring (127) for urging the pressure rollers (108,109a,109b) into pressure contact with each other, and means (124 or 132-136) for adjusting the effective force of the pressure spring (127).

4. An image-creating apparatus as claimed in claim 3 characterised in that there are means (132-136) for adjusting the point of application of the force of the pressure spring (127) at a time when the pressure rollers (108,109a) are out of contact with each other.

5. An image-creating apparatus as claimed in claim 3 characterised in that means (124) are provided for imparting force to the pressure spring (127).

6. An image-creating apparatus as claimed in claim 5 characterised in that the means for imparting force to the pressure spring (127) comprises a cam (124) mounted on a cam shaft (164), there being provided a further spring (150) and means (174,175) for selectively permitting and preventing the application of the force of the further spring (150)) to the cam shaft (164).

7. An image-creating apparatus as claimed in any preceding claim characterised by detector means (201,206) for detecting a characteristic of the sheet (s) which is to be developed, the pressure produced by the development means (100) being controlled by the detector means (201,206).

8. An image-creating apparatus as claimed in any preceding claim characterised in that the thermal treating means (400) comprises a radiation heater (401) which is arranged to heat the developed sheet (s) by radiation heat to a temperature above the softening point of the material forming the said visible image.

9. An image-creating apparatus as claimed in claim 8 characterised by a movable heat-insulating member (430) which is mounted between the heater (401) and the sheet (s) and which is movable to adjust the area of the sheet (s) which is being heated.

10. An image-creating apparatus as claimed in claim 8 or 9 characterised in that the thermal treating means (400) comprises a support member (452) for supporting the sheet (s), the support member (452) extending in a direction which is not parallel to the direction in which in operation the sheet (s) is moved through the thermal treating means (400).

11. An image-creating apparatus as claimed in any preceding claim characterised in that gas-removing means (225,226) are provided for removing gas produced in the thermal treating means (400).

12. An image-creating apparatus as claimed in claim 11 characterised in that the gas-removing means (225,226) comprises a duct (222) for discharging the said gas, a gas filter (226) being mounted in the duct (222) for removing gaseous components in the duct (222).

13. An image-creating apparatus as claimed in claim 12 characterised in that the filter (226) is provided with manually operable means (227) for introducing it into and withdrawing it from the apparatus.

14. An image-creating apparatus as claimed in claim 12 or 13 characterised in that monitor means (251) are provided for monitoring the state of the gas filter (226).

15. An image-creating apparatus as claimed in any of claims 12-14 characterised in that the gas-removing means (225,226) comprises an adsorbing portion (223) and an absorbing member (224) which are mounted on the upstream side of the gas filter (226).

16. An image-creating apparatus as claimed in claim 11 characterised in that the gas-removing means (226) is integral with the container (2) for holding the photosensitive member (f).

17. An image-creating apparatus having a photosensitive member (f) having a number of microcapsules in its surface, each of the microcapsules containing at least a colour former and a material that hardens or softens when exposed to light, and wherein the photo-sensitive member (f) is superimposed on a sheet (s) on which a visible image is to be created before or after the member (f) is exposed to an optical image, the photosensitive member (f) is subjected to pressure after the exposure, the sheet (s) is developed, and the image is fixed, said apparatus comprising:
a container (2) for holding the photosensitive member (f) therein;
an exposure means (7,9) which exposes the photosensitive member (f) to the optical image;
a container (15) for holding the sheet (s) therein;
a development means (100) which superimposes the photosensitive member (f) on the sheet (s) and develops the sheet (s) under pressure, using pressure rollers (108,109a,109b), the development means (100) being provided with a mechanism (113,124,126,127,132) for adjusting the pressure applied by the rollers (108,109a,109b); and thermal treating means (400) which thermally treats the developed sheet (s).

18. An image-creating apparatus including a photosensitive member (f) having a number of microcapsules in its surface, each of the microcapsules containing at least a colour former and a material that hardens or softens when exposed to light, and wherein the photosensitive member (f) is superimposed on a sheet (s) on which a visible image is to be created before or after the member (f) is exposed to an optical image, the photosensitive member (f) is subjected to pressure after the exposure, the sheet (s) is developed, and the image is fixed, said apparatus comprising:
a container (2) for holding the photosensitive member (f) therein;
an exposure means (7,9) which exposes the photosensitive member (f) to the optical image;
a container (15) for holding the sheet (s) therein;
a development means (100) which superimposes the photosensitive member (f) on the sheet (s) and develops the sheet (s) under pressure; and
a thermal treating means (400) which heats the developed sheets (s) by radiation heat above the softening point of the material forming the visible image.

19. An image-creating apparatus including a photo-sensitive member (f) having a number of microcapsules in its surface, each of the microcapsules containing at least a colour former and a material that hardens or softens when exposed to light, and wherein the photosensitive member (f) is superimposed on a sheet (s) on which a visible image is to be created before or after the member (f) is exposed to an optical image, the photosensitive member (f) is subjected to pressure after the exposure, the sheet (s) is developed, and the image is fixed, said apparatus comprising:

a container (2) for holding the photosensitive member (f) therein;

an exposure means (7,9) which exposes the photosensitive members (f) to the optical image;

a container (15) for holding the sheet (s) therein;

a development means (100) which superimposes the photosensitive member (f) on the sheet (s) and develops the sheet (s) under pressure;

a thermal treating means (400) which thermally treats the developed sheet (s); and

a gas-removing means (225,226) for removing the gas produced in the thermal treating means (400).

Fig. 1

EP 0 354 691 A2

Fig. 2

Fig. 3

Fig. 4

Fig. 5

Fig. 6

Fig. 7

EP 0 354 691 A2

Fig. 8

Fig. 9

Fig. 10

Fig. 11

Fig. 12

(a)  (b)  (c)

401  402  403  411  452

Fig. 13

EP 0 354 691 A2

(a)          (b)          (c)

Fig. 14

EP 0 354 691 A2

Fig. 15

EP 0 354 691 A2

Fig. 16

DC24V

solenoid

C'

H

G

SW

Fig. 17

Fig. 18

EP 0 354 691 A2

Fig. 19

400

218

222

219

225

Fig. 20

EP 0 354 691 A2

Fig. 21

Fig. 22

Fig. 23

Fig. 24

Fig. 25

Fig. 26